# EUROPÄISCHE PATENTANMELDUNG

(11) **EP 0 851 722 A1**
(43) Veröffentlichungstag der Anmeldung: **01.07.1998**
(21) Anmeldenummer: 97122074.4
(22) Anmeldetag: 15.12.1997
(51) Int. Cl.: H05K 3/34, B23K 3/02, H05K 13/04

(54) **Anordnung zum Entlöten oder Löten sowie Heizeinrichtung für eine derartige Anordnung**

(30) Priorität: 16.12.1996 DE 29621801 U
(71) Anmelder: SIEMENS AKTIENGESELLSCHAFT, 80333 München (DE)
(72) Erfinder: Ben Ameur, Raouf, 67346 Speyer (DE); Vogel, Helmut, 76307 Karlsbad (DE)

(57) **Zusammenfassung**

Die Erfindung betrifft eine Anordnung zum Entlöten oder Löten von oberflächenmontierbaren Bauelementen (11) auf Leiterplatten (10) mit einer Heizeinrichtung (12), die unmittelbar für die Anschlußelemente (13 ... 16) des Bauelements (11) vorgesehen ist und Aussparungen aufweist, durch welche Anschlußelemente (13 ... 16) des Bauelements (11) zu Anschlußflächen (22 ... 25) der Leiterplatte (10) elektrisch isoliert hindurchführbar sind. Durch eine Speiseeinrichtung (17) wird Energie in die Heizeinrichtung (12) eingespeist.

Die Erfindung wird angewandt bei oberflächenmontierbaren Bauelementen.

## Beschreibung

Die Erfindung betrifft eine Anordnung zum Entlöten oder Löten von oberflächenmontierbaren, elektronischen Bauelementen auf Leiterplatten nach dem Oberbegriff des Anspruchs 1 sowie eine Heizeinrichtung für eine derartige Anordnung.

Aus einem Sonderdruck aus "productronic" 6/7-1994, Seite 20, der Hüthig GmbH, Heidelberg, ist ein Gerät zur Reparatur von Leiterplatten bekannt, die mit elektronischen Bauelementen in BGA (Ball Grid Array)-Gehäuse bestückt sind. BGA-Gehäuse sind oberflächenmontierbar und bestehen aus Kunststoff oder Keramik. In das Gehäuse ist das eigentliche Halbleiterchip eingeschlossen. An der Unterseite des Gehäuses sind Anschlußelemente, sogenannte Balls, angebracht, die als Ball Grid Array rasterartig auf der Fläche verteilt sind. Die Anschlußelemente bestehen beispielsweise aus einem Zinn-Blei-Lot, das durch einen Dispenser als Paste aufgetragen werden kann. Zum Entlöten oder Löten eines elektronischen Bauelements mit BGA-Gehäuse wird ein Heißluftdüsenwerkzeug, das den jeweiligen geometrischen Abmessungen des elektronischen Bauelements angepaßt ist, von oben über das Bauelement gestülpt und auf die Leiterplatte aufgesetzt. Durch das Heißluftdüsenwerkzeug wird die Oberseite des elektronischen Bauelements bei zuströmender Heißluft erwärmt. Über das Bauelementegehäuse wird die Wärme zu den Balls an seiner Unterseite geleitet. Gleichzeitig wird durch eine Infrarot-Unterheizung die Leiterplatte von der gegenüberliegenden Seite her aufgeheizt, um zu verhindern, daß eine große Wärmemenge über die Leiterplatte hinweg abgeleitet wird.

Die bekannte Anordnung zum Entlöten oder Löten von elektronischen Bauelementen in BGA-Gehäusen hat aufgrund der Erwärmung von der Oberseite einige Nachteile. So ist der Wärmetransport durch das Gehäuse des Bauelements von dessen Wärmeleitfähigkeit bestimmt. Hohlräume im Gehäuse können den Vorgang sehr stören. Da die Schmelzwärme durch das Chip hindurch den Lötstellen zugeführt wird, muß das Bauelement längere Zeit über die Löttemperatur erwärmt werden, ehe die Lötstellen diese erreichen. Ist eine Unterheizung wegen einer beidseitigen Bestückung der Leiterplatte nicht möglich, dann muß auch die Wärmemenge über das elektronische Bauelement transportiert werden, die zur Aufrechterhaltung des lateralen Wärmegradienten in der Leiterplatte erforderlich ist. Elektronische Bauelemente sind daher beim Entlöten oder Löten mit der bekannten Anordnung einer erheblichen Wärmebelastung ausgesetzt.

Der Erfindung liegt die Aufgabe zugrunde, eine Anordnung zum Entlöten oder Löten von oberflächenmontierbaren, elektronischen Bauelementen auf Leiterplatten zu schaffen, durch welche ein sicherer Lötvorgang auch bei geringerer Wärmebelastung des Bauelements ermöglicht wird. Gleichzeitig ist eine Heizeinrichtung für eine derartige Anordnung vorzusehen.

Zur Lösung dieser Aufgabe weist die neue Anordnung der eingangs genannten Art die im kennzeichnenden Teil des Anspruchs 1 angegebenen Merkmale auf. Vorteilhafte Weiterbildungen sind in den abhängigen Ansprüchen beschrieben.

Die Erfindung hat den Vorteil, daß die Wärme über die Heizeinrichtung direkt den Anschlußelementen, an denen sie zum Erreichen des Schmelzpunktes benötigt wird, zugeführt werden kann. Dabei muß die Heizeinrichtung nicht zwangsläufig als zusätzliches Bauteil realisiert werden. Sie kann auch in die Leiterplatte oder in das elektronische Bauelement integriert werden, wenn diese an ihrer Oberseite bzw. an ihrer Unterseite mit einer zusätzlichen Lage zur Wärmezuführung mit einem Widerstandsheizelement oder einem gut wärmeleitenden Material versehen werden. Wenn die Heizeinrichtung als gesondertes Bauelement ausgeführt ist, kann sie auch bei elektronischen Bauelementen oder Leiterplatten eingesetzt werden, die ursprünglich nicht für die neue Anordnung zum Entlöten oder Löten konzipiert wurden. Somit ist eine Nachrüstung bestehender Bauelemente oder Leiterplatten möglich. Insbesondere bei elektronischen Bauelementen, die als Ball Grid Array ausgeführt sind, ist eine derartige Heizeinrichtung von Vorteil, da die Wärme auch den inneren Anschlußstellen, die sich zwischen Bauelement und Leiterplatte befinden und durch die Anschlußstellen im Randbereich verdeckt sind, nicht durch Bauelement oder Leiterplatte hindurch zugeleitet werden muß. Beschädigungen des Bauelements oder der Leiterplatte werden somit weitgehend vermieden. Eine Überhitzung des Bauelements wie auch der Leiterplatte kann zuverlässig ausgeschlossen werden, wenn die Heizeinrichtung bei elektrischer Energieeinspeisung aus einem Kaltleiter besteht, der wenig oberhalb der Schmelztemperatur des Lots, beispielsweise bei etwa 190 °C, eine stark abknickende Widerstands/Temperatur-Kennlinie aufweist. Die Heizeinrichtung ist besonders preiswert als einteiliges Blechbiegeteil herstellbar. Damit werden mit der neuen Anordnung lötbare Baugruppen nur unwesentlich verteuert. Mit der neuen Heizeinrichtung gestaltet sich das Verfahren zum Wechsel eines elektronischen Bauelements gegen ein anderes, z. B. zum Austausch eines Prozessors gegen einen leistungsfähigeren, besonders einfach und kann auch von ungeschultem Personal vorgenommen werden. Dazu muß lediglich eine geeignete Speiseeinrichtung angeschlossen, das elektronische Bauelement entnommen, die Bestückungsfläche vom Restlot gereinigt, ein neues Bauelement plaziert und die Speiseeinrichtung wieder entfernt werden. Teile zur Energieeinspeisung sind auch bei auf der Leiterplatte plaziertem Bauelement gut zugänglich, da sie unter dem elektronischen Bauelement herausragen.

Anhand der Figuren, in denen Ausführungsbeispiele der Erfindung dargestellt sind, werden im folgenden die Erfindung sowie Ausgestaltungen und Vorteile näher erläutert.

Es zeigen:
- Figur 1: ein elektronisches Bauelement in BGA-Ausführung,
- Figur 2: eine Heizeinrichtung für das Bauelement nach Figur 1 und
- Figur 3: ein Bauelement mit Heiz- und Speiseeinrichtung im montierten Zustand.

Wesentliches Kennzeichen oberflächenmontierbarer Bauelemente in BGA-Ausführung sind an der Unterseite eines Gehäuses 1 aus Kunststoff oder Keramik rasterartig angeordnete Anschlußelemente 2 aus einem Lot, beispielsweise einer Zinn-Blei-Legierung. Das Raster beträgt vorzugsweise 1 mm, 1,27 mm oder 1,5 mm. Die Kantenlänge des Gehäuses liegt zwischen 7 mm und 50 mm. Durch die flächenhafte Verteilung der Anschlußelemente 2 kann eine hohe Anschlußzahl erreicht werden, wie sie bei Prozessoren gefordert wird. Problematisch war bisher das Löten der inneren Anschlußelemente, da die erforderliche Wärme bisher durch das Gehäuse 1 des Bauelements oder durch die Leiterplatte den Anschlußelementen zugeführt werden mußte.

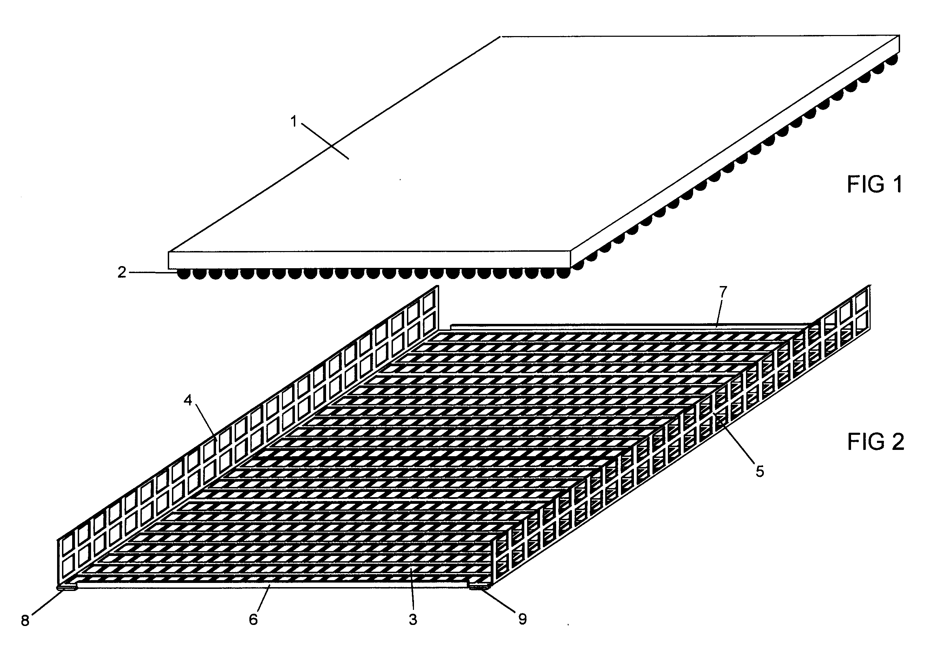

Figur 2 zeigt eine Heizeinrichtung, die zwischen dem elektronischen Bauelement in BGA-Ausführung gemäß Figur 1 und einer Leiterplatte angeordnet werden kann. Die Heizeinrichtung ist als gesondertes Bauteil ausgeführt und kann daher ohne weiteres bei herkömmlichen oberflächenmontierbaren Bauelementen und Leiterplatten verwendet werden. Sie ist als Blechbiegeteil aus einem gut wärmeleitenden Material beschaffen, damit die zum Schmelzen des Lots erforderliche Wärme schnell den einzelnen Anschlußelementen zugeführt werden kann. Vorzugsweise wird ein kunststoffbeschichtetes Kupferblech verwendet. Das Blech ist mit Aussparungen 3 versehen, deren Größe und Lage zu den Anschlußelementen 2 (Figur 1) korrespondiert und durch welche die Anschlußelemente 2 zu Anschlußflächen der Leiterplatte gegenüber der Heizeinrichtung isoliert hindurchführbar sind. An zwei einander gegenüberliegenden Seiten des Blechs sind zwei senkrecht nach oben gebogene Laschen 4 und 5 vorgesehen, über welche Energie in die Heizeinrichtung eingespeist werden kann. Wahlweise kann elektrische Energie, bei welcher die Heizeinrichtung durch ihren ohmschen Widerstand aufgeheizt wird, oder Wärmeenergie zur Aufheizung durch Wärmetransport in die Heizeinrichtung eingespeist werden. Die Laschen 4 und 5 dienen während des Betriebs des elektronischen Bauelements auch zur Abgabe der im Bauelement entstehenden Verlustwärme an die Umgebung. In einer anderen Ausgestaltung können die Laschen 4 und 5 hierzu auch als mit Kühlrippen versehener Kühlkörper oder zur Aufnahme und Halterung eines derartigen Kühlkörpers ausgebildet werden. Zur besseren Versteifung des Blechteils sind auch an den beiden übrigen Kanten senkrecht zur Bodenfläche verlaufende Stege 6 und 7 angeformt. Zur Fixierung und zur Masseverbindung der Heizeinrichtung dienen Anschlußelemente an den vier Ecken des Blechbiegeteils, von denen in Figur 2 lediglich die Anschlußelemente 8 und 9 sichtbar sind. Diese sind frei von einer isolierenden Beschichtung und werden auf Anschlußflächen der Leiterplatte gelötet. Wird durch die Anschlußelemente 8 und 9 eine Verbindung zur Ground-Lage der Leiterplatte hergestellt, so dient die Heizeinrichtung gleichzeitig als elektromagnetische Abschirmung zwischen dem elektronischen Bauelement und der Leiterplatte. Zusätzlich sorgt die Heizeinrichtung für die Einhaltung eines Mindestabstands, damit beim Lötvorgang durch einzelne Balls des BGA eine Mindestdicke nicht unterschritten wird. Dadurch werden Kurzschlüsse zwischen benachbarten Balls vermieden.

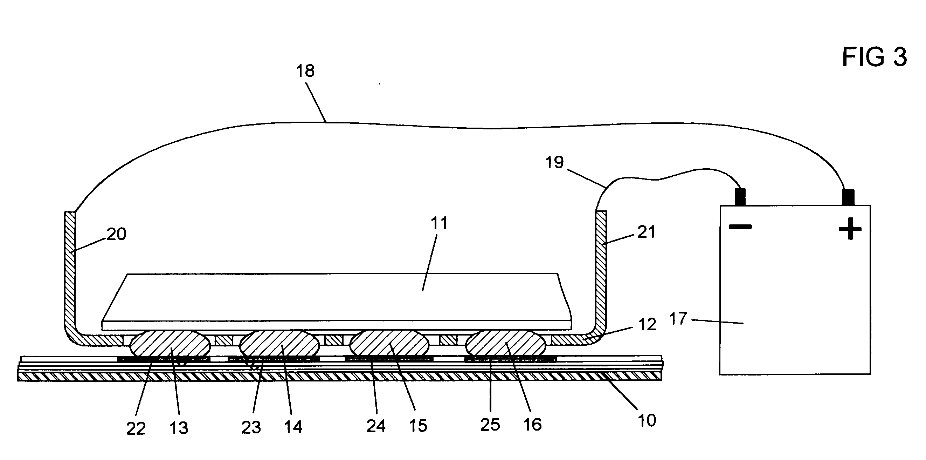

Anhand Figur 3, in der ein Schnittbild eines auf einer Leiterplatte 10 montierten elektronischen Bauelements 11 mit einer Heizeinrichtung 12 dargestellt ist, wird besonders deutlich, daß Wärme durch die Heizeinrichtung 12 direkt den Balls 13, 14, 15 und 16 des elektronischen Bauelements 11 zugeführt wird, die mit Anschlußflächen 22, 23, 24 bzw. 25 der Leiterplatte 10 verlötet sind. Der Anschaulichkeit wegen ist ein Bauelement mit nur wenigen Anschlußelementen eingezeichnet; die Vorteile werden aber um so bedeutender, je mehr Anschlußelemente das Bauelement aufweist. Die Energieeinspeisung in die Heizeinrichtung 12 erfolgt hier vereinfacht durch eine Batterie 17 als Speiseeinrichtung, die über Leitungen 18 und 19 elektrisch mit zwei Laschen 20 bzw. 21 verbunden ist, so daß ein Heizstrom durch die Heizeinrichtung 12 fließt und diese erwärmt. Selbstverständlich kann auch eine komfortablere Speiseeinrichtung mit einer Temperaturregelung durch eine Messung des elektrischen Widerstands der Heizeinrichtung oder ähnliches vorgesehen werden. Eine Übertragung der Schmelzwärme durch das Bauelement 11 oder die Leiterplatte 10 hindurch ist mit der neuen Heizeinrichtung 12 nicht mehr erforderlich.

## Patentansprüche

1. Anordnung zum Entlöten oder Löten von oberflächenmontierbaren, elektronischen Bauelementen auf Leiterplatten, **dadurch gekennzeichnet,**
- daß eine Heizeinrichtung (12) unmittelbar für die Anschlußelemente (13 ... 16) des elektronischen Bauelements (11) vorgesehen ist,
- daß die Heizeinrichtung (12) Aussparungen aufweist, durch welche Anschlußelemente (13 ... 16) des elektronischen Bauelementes (11) zu Anschlußflächen (22 ... 25) der Leiterplatte (10) gegenüber der Heizeinrichtung (12) elektrisch isoliert hindurchführbar sind, und
- daß unter dem elektronischen Bauelement (11) herausgeführte Teile (20, 21) zur Energieeinspeisung in die Heizeinrichtung (12) durch eine Speiseeinrichtung (17) vorgesehen sind.

2. Anordnung nach Anspruch 1, **dadurch gekennzeichnet,**
- daß als Speiseeinrichtung ein Heizelement vorgesehen ist, das mit den Teilen (4, 5; 20, 21) zur Energieeinspeisung wärmekoppelbar ist, und
- daß die Heizeinrichtung (12) als Wärmeleiter ausgeführt ist.

3. Anordnung nach Anspruch 1, **dadurch gekennzeichnet,**
- daß die Heizeinrichtung (12) als elektrisches Heizelement ausgeführt ist und
- daß als Speiseeinrichtung (17) eine Stromquelle vorgesehen ist, die an die Teile (20, 21) zur Energieeinspeisung elektrisch anschließbar ist.

4. Anordnung nach einem der vorhergehenden Ansprüche, **dadurch gekennzeichnet,**
- daß die Anschlußelemente (2; 13, 14, 15, 16) des elektronischen Bauelements (1; 11) als Ball Grid Array ausgeführt sind und
- daß die Heizeinrichtung (12) zumindest im Bereich zwischen elektronischem Bauelement (11) und Leiterplatte (10) eine Dicke zwischen 0,1 mm und 0,4 mm aufweist.

5. Anordnung nach einem der vorhergehenden Ansprüche, **dadurch gekennzeichnet,**
- daß die Heizeinrichtung (12) mit Anschlußelementen (8, 9) zur Lötmontage auf der Leiterplatte (10) versehen ist.

6. Anordnung nach einem der vorhergehenden Ansprüche, **dadurch gekennzeichnet,**
- daß die Heizeinrichtung (12) aus einem Metallblech besteht, das mit einem bis zumindest 200 °C temperaturbeständigen Kunststoff oder Lack beschichtet ist.

7. Anordnung nach Anspruch 6, **dadurch gekennzeichnet,**
- daß das Metallblech als Lochblech ausgebildet ist, dessen Verhältnis von Stegabstand zu Stegbreite etwa 4 : 1 beträgt und dessen Lochraster dem Anschlußraster des elektronischen Bauelements entspricht.

8. Anordnung nach einem der vorhergehenden Ansprüche, **dadurch gekennzeichnet,**
- daß die Teile (4, 5; 20, 21) zur Energieeinspeisung als neben dem elektronischen Bauelement (11) aus der Leiterplattenebene hochstehende Laschen ausgebildet sind.

9. Heizeinrichtung für eine Anordnung nach einem der vorhergehenden Ansprüche.
